(19) Europäisches Patentamt
European Patent Office
Office européen des brevets

(11) **EP 4 160 243 B1**

(12) **EUROPÄISCHE PATENTSCHRIFT**

(45) Veröffentlichungstag und Bekanntmachung des Hinweises auf die Patenterteilung:
**31.07.2024  Patentblatt 2024/31**

(21) Anmeldenummer: **21199777.0**

(22) Anmeldetag: **29.09.2021**

(51) Internationale Patentklassifikation (IPC):
**G01R 33/54** (2006.01)    **G01R 33/565** (2006.01)
**G01R 33/561** (2006.01)

(52) Gemeinsame Patentklassifikation (CPC):
**G01R 33/543; G01R 33/565;** G01R 33/5611;
G01R 33/56518; G01R 33/56572

(54) **ERMITTELUNG VON TESTPOSITIONEN FÜR EINE MITTELS EINER MAGNETRESONANZANLAGE AUFZUNEHMENDE TESTMESSUNG**

DETERMINATION OF TEST POSITIONS FOR A TEST MEASUREMENT USING A MAGNETIC RESONANCE SYSTEM

DÉTERMINATION DES POSITIONS D'ESSAI POUR UNE MESURE D'ESSAI À ENREGISTRER PAR UN SYSTÈME DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.04.2023  Patentblatt 2023/14**

(73) Patentinhaber: **Siemens Healthineers AG**
**91301 Forchheim (DE)**

(72) Erfinder:
• **Kettinger, Adam**
  **91056 Erlangen (DE)**
• **Zeller, Mario**
  **91054 Erlangen (DE)**

(74) Vertreter: **Siemens Healthineers**
**Patent Attorneys**
**Postfach 22 16 34**
**80506 München (DE)**

(56) Entgegenhaltungen:
**DE-A1- 102019 204 151    US-A1- 2013 154 639**

• **ANONYM: "Phantom Test Guidance for Use of the Large MRI Phantom for the MRI Accreditation Program 2", 2018, Internet, pages 1 - 28, XP055892745, Retrieved from the Internet <URL:https://www.acraccreditation.org/-/media/acraccreditation/documents/mri/largephantomguidance.pdf> [retrieved on 20220216]**
• **STEPHEN F. CAULEY ET AL: "Autocalibrated wave-CAIPI reconstruction; Joint optimization of k-space trajectory and parallel imaging reconstruction", MAGNETIC RESONANCE IN MEDICINE, 21 October 2016 (2016-10-21), US, XP055349317, ISSN: 0740-3194, DOI: 10.1002/mrm.26499**

**Beschreibung**

Die Erfindung betrifft ein Verfahren zur Ermittlung einer PSF für eine Rekonstruktion von Bilddaten aus mittels einer Magnetresonanzanlage aufgenommenen Messdaten.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von als Signale messbaren Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), oder auch kurz als Sequenz, bezeichnet. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Sogenannte parallele Akquisitionstechniken (ppa), wie z.B. GRAPPA ("GeneRalized Autocalibrating Partially Parallel Acquisition") oder SENSE ("Sensitivity Encoding"), bei denen mit Hilfe von mehreren RF-Spulen nur eine gemäß dem Nyquist-Theorem im k-Raum unterabgetastete Anzahl an Messdaten aufgenommen werden, können eingesetzt werden, um z.B. die für die Aufnahme der Messdaten insgesamt nötige Messzeit zu verkürzen oder die Auflösung zu erhöhen. Die "fehlenden", d.h. nicht gemessenen aber für einen gemäß Nyquist vollständigen Satz an Messdaten erforderlichen, Messdaten werden hierbei auf Basis von Sensitivitätsdaten der verwendeten RF-Spulen und Kalibrierungsdaten und den gemessenen Messdaten ergänzt.

Der Wunsch nach immer schnelleren MR-Aufnahmen im klinischen Umfeld führt auf der anderen Seite zu einer Renaissance von Verfahren, bei denen mehrere Bilder simultan aufgenommen werden. Allgemein lassen sich diese Verfahren dadurch charakterisieren, dass zumindest während eines Teils der Messung gezielt Transversalmagnetisierung von zumindest zwei Schichten gleichzeitig für den Bildgebungsprozess genutzt wird ("Multi-Schicht-Bildgebung", "Schicht-Multiplexing", "Simultaneous Multi-Slice" (SMS)). Im Gegensatz dazu wird bei der etablierten "Mehrschicht-Bildgebung" das Signal von zumindest zwei Schichten alternierend, d. h. vollständig unabhängig voneinander mit entsprechender längerer Messzeit aufgenommen. Bekannte SMS-Verfahren sind beispielsweise Verfahren, die Verfahren aus der oben genannten Bildgebung mittels ppa, bei welchen Wissen über die Sensitivitätsverteilung der bei dem Erfassen der Messdaten eingesetzten Empfangsspulen als zusätzliche Information genutzt wird, um gemäß Nyquist unterabgetastete Messdaten aufzufüllen, in Schicht-Richtung einsetzen, um überlagert aus mehreren Schichten aufgenommene Signale in Signale der einzelnen Schichten zu separieren. Zu diesen Verfahren gehören beispielsweise auch die CAIPIRINHA-Technik, wie sie von Breuer et al. in "Controlled Aliasing in Parallel Imaging Results in Higher Acceleration (CAIPIRINHA) for Multi-Slice Imaging", Magnetic Resonance in Medicine 53, 2005, S. 684-691 beschrieben ist, und die blipped CAIPIRINHA-Technik, wie sie von Setsompop et al. in "Blipped-Controlled Aliasing in Parallel Imaging for Simultaneous Multislice Echo Planar Imaging With Reduced g-Factor Penalty", Magnetic Resonance in Medicine 67, 2012, S. 1210-1224, beschrieben wird, wobei der im letztgenannten Titel genannte g-Faktor ("gfactor", kurz für "Geometrie-Faktor") ein Maß für eine Trennbarkeit der verschiedenen verwendeten Empfangsspulen darstellt.

Als ein Verfahren diesen g-Faktor weiter zu reduzieren ist es für CAIPIRINHA-Verfahren weiterhin bekannt, die Auslesetrajektorien im k-Raum, und damit das Akquisitionsschema, derart zu verändern, dass die Messdaten entlang von wellenförmig oder schraubenförmig verlaufenden Auslesetrajektorien erfasst werden. Dies ist beispielsweise in der US8981776B2, in dem Artikel von Bilgic et al. "Wave-CAIPI for Highly Accelerated 3D Imaging", Magnetic Resonance in Medicine 73:2152-2162 (2015), oder, für zweidimensionale (2D) Bildgebung in Chen et al. "Self-Calibrating Wave-Encoded Variable-Density Single-Shot Fast Spin Echo Imaging", J. Magn. Reson. Imaging 2018, 47:954-966, oder auch für Spinecho(SE)-Verfahren in Gagoski et al. "RARE/Turbo Spin Echo Imaging with Simultaneous Multislice Wave-CAIPI", Magn. Reson. Med. 73:929-938 (2015) beschrieben.

Kurz gesagt, werden für derartige Wave-Techniken während des Auslesevorgangs gleichzeitig mit einem Gradienten in Ausleserichtung zumindest ein sinusförmig modulierter Gradient in eine senkrecht zu der Ausleserichtung stehenden Richtung ausgespielt. Eine auf diese Weise erhaltene wellen- oder schraubenförmige k-Raumtrajektorie verteilt Artefakte, wie z.B. Aliasing-Artefakte, wie sie durch eine zur Verkürzung der Messzeit angewandte Unterabtastung des k-Raums auftreten, in zumindest zwei, oder, für schraubenförmige k-Raumtrajektorien, in alle räumlichen Richtungen, und ermöglicht es somit, auch Sensitivitätsdaten der verwendeten RF-Spulen in mehreren (allen drei) Raumrichtungen einsetzten zu können, was zu der erwähnten Reduzierung des g-Faktors führt. Somit können mit Wave-Techniken z.B. höhere Beschleunigungen, also eine stärkere Unterabtastung, angewandt werden, bei gleichbleibender Qualität der erhaltenen Bilddaten gegenüber "nicht-Wave-ppa-Techniken" mit geringerer Beschleunigung.

Die Wirkung der modulierten, auch Wave-Gradienten genannten, Gradienten auf eine Magnetisierung m an einem räumlichen Punkt Wave(x,y,z) kann als eine Multiplikation mit einer sogenannten "Point-Spread-Funktion" PSF, welche die Ausbreitung von Aliasing-Artefakten von Unterabtastungsschemata beschreibt, beschrieben werden:

$$\text{Wave}(x,y,z) = F^{-1}_x \ \text{PSF}(k_x,y,z) \ F_x m(x,y,z),$$

wobei $F_x$ für eine Fouriertransformation und $F^{-1}_x$ für die inverse Fouriertransformation und PSF($k_x$,y,z) für die in dem hybriden $k_x$-y-z-Raum dargestellte PSF für einen Wave Gradienten, stehen. Die PSF beschreibt die Wirkung der modulierten Gradienten auf die Bildgebungsphase in $k_x$-Richtung und kann in jeweils von y und z abhängige Terme separiert werden. Wie in dem bereits genannten Artikel von Bilgic et al. können daher Aliasing-Artefakte durch "Unaliasing" mittels einer SENSE-Rekonstruktion aufgehoben werden. Dies ist beispielsweise genauer in dem Artikel von Polak et al. "Highly-Accelerated Volumetric Brain Examination Using Optimized Wave-CAIPI Encoding", J. Magn. Reason. Imaging 2019, 50:961-974, beschrieben.

Idealerweise sind die PSF von sinusoidal bzw. cosinusoidal modulierten Gradienten ebenfalls sinusoidal bzw. cosinusoidal. Daher sollte eine durch eine Fouriertransformation einer solchen PSF erhaltene Modulations-Transfer-Funktion MTF nur eine Frequenzkomponente haben. In der Realität ist ein durch eine MTF beschriebenes Spektrum einer realen PSF jedoch in der Regel durch Imperfektionen der während des Auslesevorgangs eingesetzten Gradienten, die z.B. durch Wirbelströme und Verzögerungen in den geschalteten Gradienten etc. verursacht sein können, verbreitert. Daher führt eine Rekonstruktion von Bilddaten welche ein ideales PSF verwendet zu einem Verschwimmen (engl. "blurring") in den Rekonstruierten Bilddaten.

Somit erweisen sich Wave-Techniken als besonders sensitiv gegenüber Imperfektionen der während des Auslesevorgangs eingesetzten Gradienten, sodass Abweichungen der tatsächlich während einer Messung erzeugten Gradienten während einer Auslesezeitspanne von den jeweiligen idealen, für diese Auslesezeitspanne geplanten Gradienten zu Artefakten in den letztendlich erhaltenen Bilddaten führen.

Derartige Abweichungen von tatsächlich während einer Messung erzeugten Gradienten während einer Auslesezeitspanne von den jeweiligen für diese Auslesezeitspanne geplanten Gradienten treten jedoch regelmäßig auf, z.B. aufgrund von hohen Strömen in den jeweiligen Gradientenspulen und dadurch verursachten Effekten wie Wirbelströmen, Feldern höherer Ordnung etc.

Es wird bereits versucht, die negativen Effekte der oben genannten Abweichungen durch Beachten von bekannten, statischen, konstanten Zeitverzögerungen der jeweiligen Gradientenspulen retrospektiv bei der Rekonstruktion abzumildern. Dieses Vorgehen lässt jedoch frequenzabhängige Komponenten der Verzögerungen in den geschalteten Gradienten und dadurch verursachten Abweichungen sowie jegliche Abweichungen der erreichten Magnituden der geschalteten Gradienten von den geplanten Gradienten außer Acht, wodurch durch diesen unflexiblen Ansatz nur eine möglicherweise unzureichende Beseitigung von Artefakten erreicht werden kann.

Aus der US 2013/0154639 A1 ist ein Verfahren bekannt, bei welchem ein Gesichtsfeld (FOV, engl. "field of view") anhand von Forminformationen angepasst wird. Das American College of Radiology (ACR) hat ein Dokument zur Handlungsempfehlung für Phantomtests zur Beurteilung des Leistungsvermögens von MR-Systemen für ihr Akkreditierungsprogramm veröffentlicht, "Phantom Test Guidance for the ACR MRI Accreditation Program", 2018.

Weiterhin wurde z.B. in dem Artikel von Cauley et al. "Autocalibrated Wave-CAIPI Reconstruction; Joint Optimization of k-Space Trajectory and Parallel Imaging Reconstruction", Magnetic Resonance in Medicine 78, 2017, S. 1093-1099, ein iteratives Verfahren beschrieben, welches Frequenzparameter der sogenannten "Point-Spread-Funktion" PSF, welche die Ausbreitung von Aliasing-Artefakten von Unterabtastungsschemata beschreibt, variiert und die mit den verschiedenen Frequenzparametern erhaltenen Rekonstruktionsergebnisse an ausgewählten Testpositionen über deren mittleren quadratischen Fehler (RMSE, engl. "root-mean-square-error") vergleicht. Nähert sich der RMSE einem lokalen Minimum, wird der zugehörige Wert des Frequenzparameters als derjenige der gesuchten PSF angenommen. Auf Grundlage der gefundenen PSF wird eine Korrektur der Abweichung der Gradienten für Wave-k-Raumtrajektorien beschrieben. Ein Nachteil dieses Verfahrens ist jedoch eine möglicherweise lange Zeit, die benötigt wird, um die gesuchten PSF zu finden.

Der Erfindung liegt die Aufgabe zugrunde, Verfahren, welche Testmessungen an Testpositionen eines Untersuchungsobjektes verwenden, zu verbessern.

Die Aufgabe wird gelöst durch ein Verfahren zur Ermittlung mindestens einer Testposition für eine mittels einer Magnetresonanzanlage aufzunehmende Testmessung gemäß Anspruch 1, eine Magnetresonanzanlage gemäß Anspruch 13, ein Computerprogramm gemäß Anspruch 14, sowie einen elektronisch lesbaren Datenträger gemäß Anspruch 15.

Ein erfindungsgemäßes Verfahren zur Ermittlung mindestens einer Testposition für eine mittels einer Magnetresonanzanlage aufzunehmende Testmessung umfasst die Schritte:

- Aufnehmen eines Testbildes,
- Wählen mindestens einer Testposition auf Basis des Testbildes,

wobei das Wählen von Testpositionen ein Zuordnen von Testpositionen zu erlaubten Testpositionen und gesperrten Testpositionen, gemäß einer auf Intensitätswerten des Testbildes an Testpositionen basierenden Zuordnungsfunktion umfasst.

Der Erfindung liegt die Erkenntnis zugrunde, dass bei Anwendungen, welche Daten von Testmessungen einer Magnetresonanzanlage benötigen, ein erreichbares Ergebnis von der Qualität der für die Testmessungen gewählten Testpositionen in dem Zielvolumen der Messung abhängt.

Insbesondere für Verfahren zum Kompensieren von Effekten von Abweichungen tatsächlich während einer Auslesezeitspanne erzeugter Gradienten von für diese Auslesezeitspanne geplanten Gradienten, z.B. gerade für eine PSF-Bestimmung wie sie in dem oben genannten Artikel von Cauley et al. beschrieben ist, kann mit dem erfindungsgemäßen Wählen von Testpositionen auf Basis eines Testbildes sichergestellt werden, dass die Testpositionen in einem für die Testmessung günstigen Aufnahmebereich, z.B. auch innerhalb eines zu untersuchenden Untersuchungsobjektes im Testbild, liegen. Damit kann eine höhere Bildqualität in MR-Bildern, die unter Verwendung von an erfindungsgemäß positionierten Testpositionen erfolgten Testmessungen erzeugt wurden, erreicht werden.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Testposition-Bestimmungseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Fig. 1 ein schematisches Ablaufdiagram eines erfindungsgemäßen Verfahrens,

Figs. 2-5 beispielhafte Verteilungen von Testpositionen,

Fig. 6 eine schematisch dargestellte erfindungsgemäße Magnetresonanzanlage.

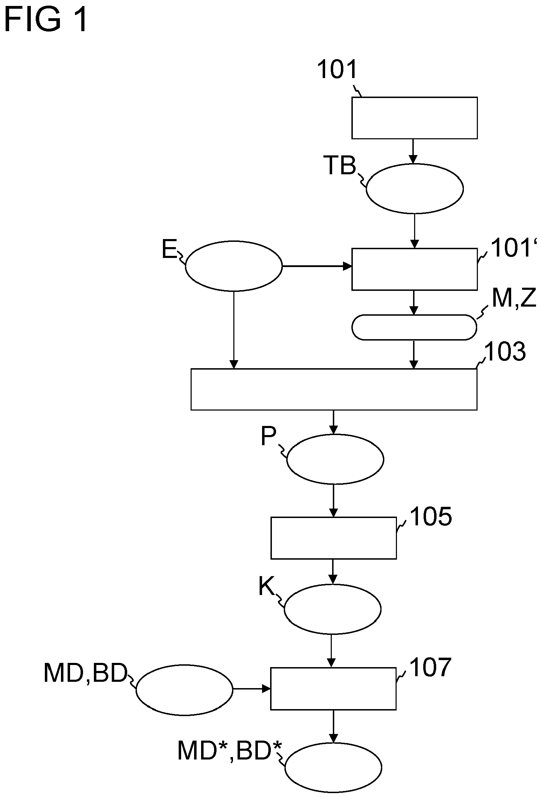

Figur 1 ist ein schematisches Ablaufdiagramm eines erfindungsgemäßen Verfahrens zur Ermittlung mindestens einer Testposition für eine mittels einer Magnetresonanzanlage aufzunehmende Testmessung.

Dabei wird ein Testbild B aufgenommen (Block 101). Bei dem Testbild B kann es sich beispielsweise um ein aus im Rahmen von einem Vorab-Scan (engl. "pre-scan") aufgenommenen Daten, insbesondere Kalibrierungsdaten, rekonstruiertes Testbild B handeln. Kalibrierungsdaten werden häufig in Verbindung mit MR-Messungen aufgenommen, z.B. um Messparameter zu justieren und/oder Spulensensitivitätsdaten zu bestimmen, und haben in der Regel eine geringere Auflösung als für diagnostische MR-Bilder aufgenommene Messdaten. Somit sind sie schnell zu berechnen und bedürfen weniger Speicherplatz. Es ist jedoch auch möglich, dass das Testbild B ein aus für eine gewünschte Untersuchung eines Untersuchungsobjektes aufgenommenen Messdaten rekonstruiertes MR-Bild ist.

Auf Basis des Testbildes B wird mindestens eine Testposition P gewählt (Block 103).

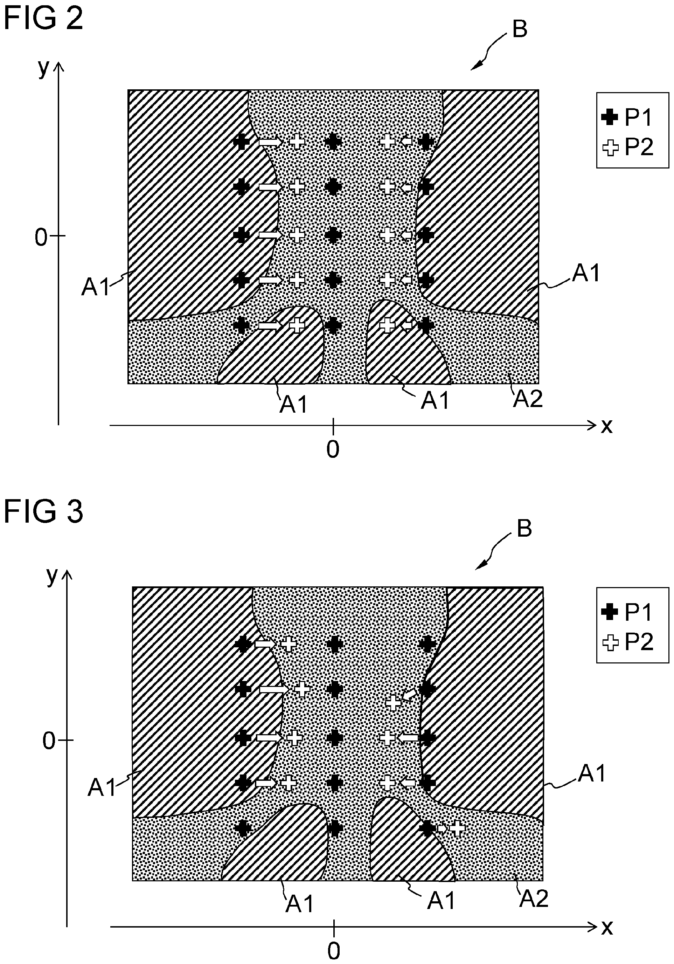

Dabei sind verschiedene Vorgehensweisen denkbar. Beispiele hierzu werden anhand der Figuren 2 bis 5 beschrieben.

Das Wählen der mindestens einen Testposition kann auf Basis eines ersten vorgegebenen Testgitters erfolgen, das eine Anzahl an Testpositionen und deren Verteilungsmuster in einem dargestellten Zielbereich des Testbildes B festlegt. Das Testgitter kann z.B. ein kartesisches Testgitter oder ein hexagonales Testgitter sein. Das Testgitter kann fest vorgegeben sein. Es ist auch möglich, das Testgitter mittels einer Nutzereingabe E festzulegen.

Auf Basis des Testbildes B wird eine Zuordnungsfunktion M ermittelt, die Testpositionen erlaubten Testpositionen (z.B. in günstigen Bereichen A2 des Testbildes) oder gesperrten Testpositionen (z.B. in ungünstigen Bereichen des Testbildes B) zuordnet (Block 101'). Die Zuordnungsfunktion M basiert auf Intensitätswerten des Testbildes B und kann z.B. einen minimalen Intensitätswert berücksichtigen. Bereiche des Testbildes B, die den minimalen Intensitätswert erreichen, können als günstig für eine Positionierung einer Testposition gekennzeichnet werden, und Bereiche des Testbildes B, die den minimalen Intensitätswert nicht erreichen, können als ungünstig für eine Positionierung einer Testposition gekennzeichnet werden. Ein minimaler Intensitätswert kann fest vorgegeben sein oder durch eine Nutzereingabe E festgelegt werden.

Beispielsweise kann die Zuordnungsfunktion M in Form einer binären Maske ermittelt werden, welche Testpositionen, welche in einem Bereich A1 des Testbildes B liegen, in welchen ein minimal geforderter Intensitätswert nicht erreicht wird, sperrt, und welche Testpositionen, welche in einem Bereich A2 des Testbildes B liegen, in welchen ein minimal geforderter Intensitätswert erreicht wird, erlaubt.

Auf diese Weise können negative Effekte von in ungünstigen, insbesondere intensitätsarmen und damit rauschbehafteten, Bereichen des Testbildes liegenden Testpositionen vermieden werden, da solche Testpositionen gesperrt werden. Beispielsweise bei einer Bestimmung von PSFs an Testpositionen für eine verbesserte Rekonstruktion von mittels einer Wave-Technik aufgenommenen Messdaten, wie sie z.B. in dem bereits genannten Artikel von Cauley et al. beschrieben ist, wird auf diese Weise gleichzeitig die benötigte Rechenzeit reduziert, da weniger Testpositionen erlaubt sind.

Das Wählen von Testpositionen kann auch ein Gewichten von Testpositionen gemäß einem von einem Intensitätswert des Testbildes an einer jeweiligen, insbesondere einer erlaubten, Testposition abhängigen Gewichtungsfaktor umfasst. Dabei kann der Gewichtungsfaktor einer Testposition von dem an der Testposition im Testbild vorliegenden Intensitätswert direkt proportional abhängen. Es ist jedoch auch denkbar Gewichtungsfaktoren gestaffelt zu wählen. Beispielsweise für alle Testpositionen, die im Testbild einen Intensitätswert haben, der größer oder gleich einem bestimmten geforderten Intensitätswertes des Testbildes B ist, z.B. einem gemäß Mittelwert oder auch Median als mittleren Intensitätswert bestimmten geforderten Intensitätswert, kann der Gewichtungsfaktor auf den Wert Eins gesetzt werden. Für alle Testpositionen, die im Testbild einen Intensitätswert haben, der kleiner oder gleich einem bestimmten minimalen Intensitätswertes des Testbildes B ist, z.B. einem Intensitätswert von maximal 5% des mittleren Intensitätswertes des Testbildes B, kann der Gewichtungsfaktor auf den Wert Null gesetzt werden. Für Testpositionen mit einem Intensitätswert im Testbild B, der zwischen dem geforderten Intensitätswert und dem minimalen Intensitätswert ist, kann der Gewichtungsfaktor z.B. linear oder kubisch oder gemäß einer (Quadrat-)Wurzelfunktion von dem Wert Eins zu dem Wert Null verlaufend gesetzt werden. Einem Gewichten mit dem Gewichtungsfaktor Null entspricht hierbei einem Sperren der Testposition.

Ein derartiges Gewichten kann z.B. einfach in einer Zuordnungsfunktion M, insbesondere in Form einer gewichteten Maske, realisiert werden.

Durch ein derartiges Gewichten kann erreicht werden, dass weniger Testpositionen gesperrt werden, wobei trotzdem der Einfluss von in ungünstigeren Bereichen des Testbildes B positionierten Testpositionen reduziert ist. Die Verwendung von mehr Testpositionen kann eine stabilisierende Wirkung (z.B. über Mittelungseffekte) haben.

Figur 2 zeigt eine erste beispielhafte Verteilung von Testpositionen in einem Testbild B. Dabei sind erste Testpositionen P1 gemäß einem ersten Testgitter an vorgegebenen Koordinaten in die beiden Richtungen (hier: x-Richtung und y-Richtung) des Testbildes B positioniert.

Dabei kann das vorgegebene erste Testgitter das Zielvolumen des Testbildes B, zumindest aber einen zentralen Bereich des Testbildes B und/oder einen Bereich, in welchem das zu untersuchenden Untersuchungsobjekt vermutet wird, gleichmäßig abdecken.

Von den beispielhaft dargestellten 15 ersten Testpositionen P1 liegen 7 in einem z.B. durch eine Zuordnungsfunktion als ungünstig bewerteten Bereich A1. Diese Testpositionen in einem als ungünstig bewerteten Bereich A1 werden gesperrt.

Gesperrte Testpositionen, beispielsweise die in Figur 2 in dem Bereich A1 befindlichen ersten Testpositionen P1, können allerdings auch auf zweite Testpositionen P2 verschoben werden. Derartige zweite Testpositionen P2 werden wiederum gemäß der Zuordnungsfunktion zu erlaubten (z.B. in dem Bereich A2 liegenden) oder gesperrten (in dem Bereich A1 liegenden) Testpositionen zugeordnet.

Ein Verschieben erster Testpositionen P1 kann für Zeilen oder Spalten des ersten Testgitters zeilenweise oder spaltenweise auf zweite Testpositionen P2 erfolgen. Derartige Verschiebungen sind leicht zu berechnen. Das Verschieben kann hierbei nach Art einer binären Suche erfolgen, um trotzdem eine möglichst gleichmäßige Verteilung zu erreichen.

Eine derartige binäre Suche kann erreicht werden, z.B. indem die Verschiebung zunächst um die halbe Distanz zwischen dem Gitterpunkt einer zu verschiebenden Testposition zum nächstliegenden Gitterpunkt in Richtung Bildzentrum des ersten Testgitters hin erfolgt, wo erneut eine Prüfung der verschobenen Testpositionen mittels der Zuordnungsfunktion durchgeführt wird. Wenn dort alle oder die meisten der zu verschiebenden Testpositionen P1 in dem günstigen Bereich A2 liegen, kann erneut, nun z.B. um ein Viertel der halben Distanz zwischen dem Gitterpunkt der zu verschiebenden Testposition zum nächstliegenden Gitterpunkt jetzt in die entgegengesetzte Richtung verschoben werden, wo wiederum erneut eine Prüfung der verschobenen Testpositionen mittels der Zuordnungsfunktion durchgeführt wird. Wenn dort mehr der zu verschiebenden Testpositionen P1 in dem günstigen Bereich A2 liegen, kann erneut, nun z.B. um ein Achtel der halben Distanz zwischen dem Gitterpunkt der zu verschiebenden Testposition zum nächstliegenden Gitterpunkt wieder in die entgegengesetzte Richtung verschoben werden. Wenn dort weniger als bei der letzten Prüfung der zu verschiebenden Testpositionen P1 in dem günstigen Bereich A2 liegen, kann erneut, nun z.B. um ein Achtel der halben Distanz zwischen dem Gitterpunkt der zu verschiebenden Testposition zum nächstliegenden Gitterpunkt wieder in die ursprüngliche Richtung verschoben werden.

In Figur 2 ist beispielhaft dargestellt, wie erste Testpositionen P1 einer Spalte des Testgitters (d.h. mit einer gleichen x-Koordinate), die zumindest teilweise, bevorzugt überwiegend, gesperrt sind (weil sie in dem Bereich A1 liegen) auf zweite Testpositionen P2 verschoben werden können (Pfeile). Das Verschieben erfolgt bevorzugt in Richtung des Bildzentrums des Testbildes B hin (in der Verschieberichtung, hier x-Richtung), so, dass mit hoher Wahrscheinlichkeit ein Bereich A2 erreicht wird, der als günstig eingestuft ist. In dem gezeigten Beispiel der Figur 2 sind nach dem Verschieben nur noch zwei der 15 Testpositionen gesperrt (die hier an zweiten Testpositionen P2 in einem Bereich A1 liegen).

Zusätzlich oder alternativ können einzelne gesperrte erste Testpositionen P1 auf zweite Testpositionen P2 in mindestens einer Raumrichtung (x,y) des Testbildes B in Richtung des Bildzentrums (0,0) des Testbildes B hin oder auf eine zweite Testposition P2 mit einem gewünschten Intensitätswert im Testbild B hin verschoben werden. Dadurch kann erreicht werden, dass alle gesperrten ersten Testpositionen P1 auf erlaubte zweite Testpositionen P2 verschoben werden. Hierbei kann zusätzlich auf eine möglichst gleichmäßige Verteilung der erlaubten Testpositionen P1 und P2 und/oder eine Positionierung der erlaubten Testpositionen P1 und P2 in dem günstigen Bereich A2 an Positionen mit hohen Intensitätswerten, geachtet werden.

Dies ist in Figur 3 veranschaulicht, in der von einer gleichen beispielhaften Verteilung erster Testpositionen P1 gemäß einem ersten Testgitter in einem Testbild B wie in Figur 2 gezeigt ausgehend, gesperrte erste Testpositionen P1 individuell auf zweite Testpositionen P2 verschoben werden (Pfeile) .

Weiterhin können Kandidatentestpositionen P0 gemäß einem zweiten vorgegebenen Testgitter positioniert werden, welches engmaschiger ist als das erste Testgitter. Die Kandidatentestpositionen P0 können wiederum gemäß der Zuordnungsfunktion M zu erlaubten oder gesperrten Testpositionen zugeordnet werden, und gesperrte erste Testpositionen auf, z.B. räumlich nächstgelegene, erlaubte Kandidatenpositionen verschoben werden.

Das zweite Testgitter kann hierbei das Testbild B wiederum gleichmäßig bedecken. Beispielsweise kann das zweite Testgitter das erste Testgitter umfassen, und eine Maschenweite haben, die der halben Maschenweite des ersten Testgitters entspricht.

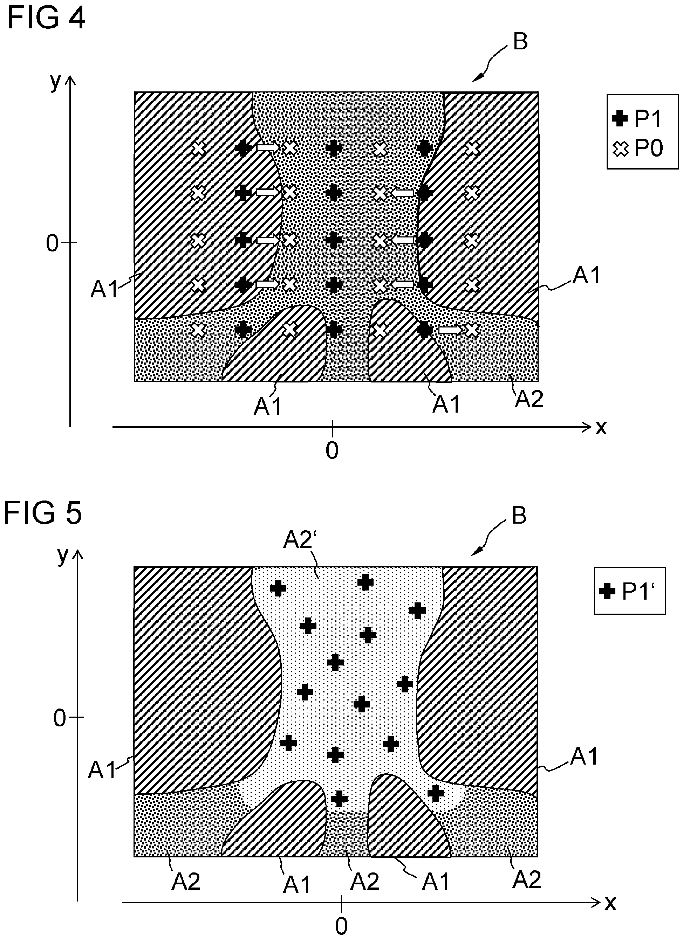

Ein derartiges Beispiel ist in der Figur 4 gezeigt, in der von einer gleichen beispielhaften Verteilung erster Testpositionen P1 gemäß einem ersten Testgitter in einem Testbild B wie in Figur 2 gezeigt ausgehend, gesperrte erste Testpositionen P1 auf nächstliegende erlaubte (in einem Bereich A2 liegende) Kandidatenpositionen P0 eines zweiten Testgitters verschoben werden (Pfeile).

Weiterhin ist es denkbar, dass das Wählen von Testpositionen P1' ein Verteilen einer vorgegebenen Anzahl an Testpositionen P1' in einem gemäß einem auf Intensitätswerten des Testbildes B basierenden Zulassungskriterium Z zugelassenen Bereich A2' umfasst. Das Zulassungskriterium Z kann z.B. mittels einer Segmentierung des Testbildes B einen zugelassenen Bereich A2' derart festlegen, dass der zugelassene Bereich das zu untersuchende Untersuchungsobjekt abbildet. Zusätzlich oder alternativ kann das Zulassungskriterium Z einen vorgegebenen minimalen Intensitätswert festlegen, der in dem zugelassenen Bereich A2 erreicht werden muss. Insbesondere kann das Zulassungskriterium Z auch eine als binäre Maske ausgestaltete Zulassungsfunktion M sein. Eine gewünschte Anzahl an Testpositionen P1' und/oder ein minimaler Intensitätswert kann fest vorgegeben sein, oder durch eine Nutzereingabe E festgelegt werden.

Ein derartiges Beispiel ist in der Figur 5 gezeigt, in der Testpositionen P1' in dem zugelassenen Bereich A2' verteilt sind.

Die Verteilung der Testpositionen P1' kann hierbei beispielsweise mittels einem greedy Algorithmus, der die Testpositionen an Gitterpunkte eines vorgegebenen oder gewählten (z.B. kartesischen oder hexagonalen) Verteilungsgitters erfolgen. Das Verteilungsgitter kann einen Abstand zwischen seinen Gitterpunkten haben, der dem Abstand der Gitterpunkte eines Testgitters entspricht. Das Verteilungsgitter kann ein Testgitter sein.

In einer Abwandlung dieser Ausgestaltung kann die Verteilung der Testpositionen P1' mittels einem dynamischen greedy Algorithmus erfolgen, welcher die Testpositionen P1' nicht an festen Gitterpunkten des Verteilungsgitters, sondern in durch einen gewählten Radius vorgegebenen Kreisen um dessen Gitterpunkte herum verteilt.

Zusätzlich oder alternativ kann ein Verteilen der Testpositionen P1' ein Finden eines Verteilungsgleichgewichts gemäß einem "electron scattering"-Verfahren umfassen, bei welchem Testpositionen P1' je eine gleichartige Ladung zugeschrieben wird und gemäß elektrischer Abstoßung eine optimale Verteilung in dem zugelassenen Bereich A2 simuliert wird. Dabei kann beispielsweise auch einem Rand des zugelassenen Bereichs A2' eine Ladung zugeschrieben werden oder eine geeignete Randbedingung verwendet werden, um ein Anordnen der Testpositionen P1' nur entlang des Randes des zugelassenen Bereichs A2' zu verhindern. Als derartige Randbedingung kommen beispielsweise periodische oder toroidale Randbedingungen in Frage, die gegenüberliegende Ränder des zugelassenen Bereichs A2' als quasi nebeneinanderliegend verbinden, und so die Ränder auflösen.

An erfindungsgemäß ausgewählten ermittelten Testpositionen können Testmessungen durchgeführt werden, die Testergebnisse K liefern (Block 105).

Die Testpositionen können für Verfahren zum Kompensieren von Effekten von Abweichungen tatsächlich während einer Auslesezeitspanne erzeugter Gradienten von für diese Auslesezeitspanne geplanten Gradienten ermittelt werden. Beispielsweise können als Testergebnisse K PSF-Werte gemessen werden.

Die Testergebnisse können bei der Verarbeitung von weiteren mittels der Magnetresonanzanlage, insbesondere unter Verwendung einer Wave-Technik, aufgenommenen Messdaten MD und/oder Bilddaten BD verwendet werden, wodurch verarbeitete, insbesondere korrigierte Messdaten MD* oder Bilddaten BD* hoher Bildqualität erhalten werden (Block 107).

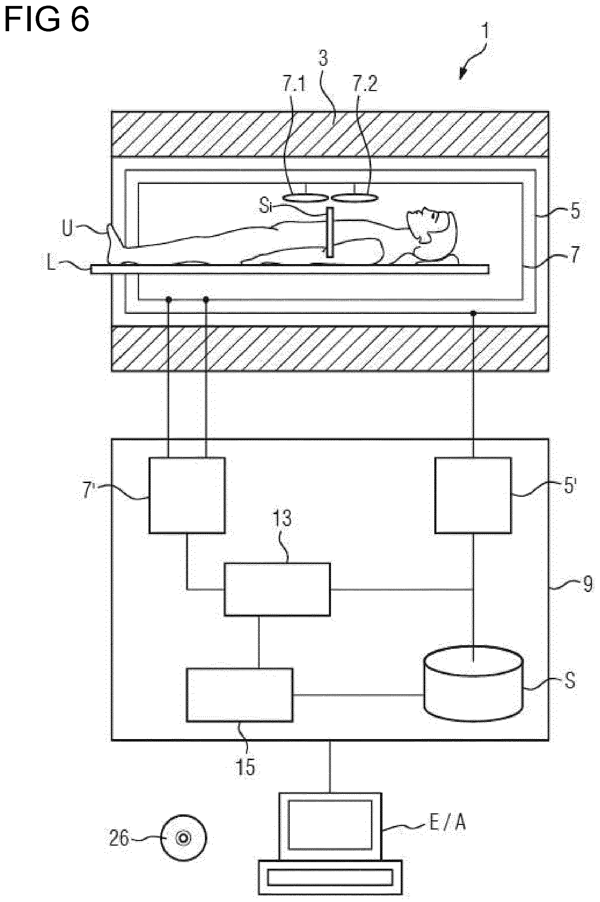

Figur 6 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 6 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht oder der Slab $S_i$ stellt ein exemplarisches Zielvolumen des Untersuchungsobjekts dar, aus dem Echosignale aufgenommen und als Messdaten erfasst werden sollen.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Testposition-Bestimmungseinheit 15, mit welcher erfindungsgemäße Testpositionen bestimmt werden können. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

**Patentansprüche**

**1.** Verfahren zur Ermittlung mindestens einer Testposition für eine mittels einer Magnetresonanzanlage aufzunehmende Testmessung umfassend die Schritte:

- Aufnehmen eines Testbildes (B),
- Wählen mindestens einer Testposition (P, P1, P1', P2) auf Basis des Testbildes (B),

wobei das Wählen von Testpositionen (P, P1, P1', P2) ein Zuordnen von Testpositionen (P, P1, P1', P2) zu erlaubten Testpositionen und gesperrten Testpositionen, gemäß einer auf Intensitätswerten des Testbildes (B) an Testpositionen (P, P1, P1', P2) basierenden Zuordnungsfunktion (M) umfasst.

2. Verfahren nach Anspruch 1, wobei erste Testpositionen (P1) gemäß einem vorgegebenen ersten Testgitter in dem Testbild (B) positioniert sind.

3. Verfahren nach Anspruch 2, wobei das vorgegebene erste Testgitter ein Zielvolumen des Testbildes (B) gleichmäßig abdeckt.

4. Verfahren nacheinem der vorhergehenden Ansprüche, wobei die Zuordnungsfunktion (M) einen minimalen Intensitätswert berücksichtigt.

5. Verfahren nach einem der vorhergehenden Ansprüche, wobei das Wählen von Testpositionen (P, P1, P1', P2) ein Gewichten von Testpositionen (P, P1, P1', P2) gemäß einem von einem Intensitätswert des Testbildes (B) an einer jeweiligen Testposition abhängigen Gewichtungsfaktor umfasst, wobei ein Gewichten mit dem Gewichtungsfaktor Null einem Sperren der Testposition (P, P1, P1', P2) entspricht.

6. Verfahren nach einem der vorhergehenden Ansprüche, wobei gesperrte Testpositionen, insbesondere gesperrte erste Testpositionen (P1), auf zweite Testpositionen (P2) verschoben werden, die gemäß der Zuordnungsfunktion (M) zu erlaubten oder gesperrten Testpositionen zugeordnet werden.

7. Verfahren nach Anspruch 6, wobei das Verschieben erster Testpositionen (P1) für Zeilen oder Spalten des ersten Testgitters zeilenweise oder spaltenweise erfolgt.

8. Verfahren nach Anspruch 6, wobei einzelne gesperrte erste Testpositionen (P1) auf zweite Testpositionen (P2) in mindestens eine Raumrichtung (x,y) des Testbildes (B) in Richtung des Bildzentrums des Testbildes (B) hin oder auf eine zweite Testposition (P2) mit einem gewünschten Intensitätswert im Testbild (B) hin verschoben werden.

9. Verfahren nach einem der vorhergehenden Ansprüche, wobei Kandidatentestpositionen (P0) gemäß einem zweiten vorgegebenen Testgitter, welches engmaschiger ist als das erste Testgitter, positioniert und gemäß dem Zuordnungsfunktion (M) zu erlaubten oder gesperrten Testpositionen zugeordnet werden, und gesperrte erste Testpositionen (P1) auf erlaubte, insbesondere auf räumlich nächstgelegene erlaubte, Kandidatenpositionen (P0) verschoben werden.

10. Verfahren nach einem der vorhergehenden Ansprüche, wobei das Wählen von Testpositionen (P, P1') ein Verteilen einer vorgegebenen Anzahl an Testpositionen (P, P1') in einem gemäß einem auf Intensitätswerten des Testbildes (B) basierenden, insbesondere einen vorgegebenen minimalen Intensitätswert festlegenden, Zulassungskriterium (Z) zugelassenen Bereich (A2') umfasst.

11. Verfahren nach einem der vorhergehenden Ansprüche, wobei die Testpositionen für Verfahren zum Kompensieren von Effekten von Abweichungen tatsächlich während einer Auslesezeitspanne erzeugter Gradienten von für diese Auslesezeitspanne geplanten Gradienten, insbesondere für eine PSF-Bestimmung, ermittelt werden.

12. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Testposition-Bestimmungseinheit (15), wobei die Steuereinrichtung (9) dazu ausgebildet ist, ein Verfahren nach einem der Ansprüche 1 bis 11 auf der Magnetresonanzanlage (1) auszuführen.

13. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 11 auszuführen, wenn das Programm in der Steuereinrichtung (9) der Magnetresonanzanlage (1) ausgeführt wird.

**14.** Elektronisch lesbarer Datenträger mit darauf gespeicherten elektronisch lesbaren Steuerinformationen, welche zumindest ein Computerprogramm nach Anspruch 13 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 11 durchführen.

**Claims**

**1.** Method for determining at least one test position for a test measurement to be recorded by means of a magnetic resonance system, comprising the steps:

- recording a test image (B),
- selecting at least one test position (P, P1, P1', P2) on the basis of the test image (B),

wherein the selection of test positions (P, P1, P1', P2) comprises an assignment of test positions (P, P1, P1', P2) to permitted test positions and blocked test positions, according to an assignment function (M) based on intensity values of the test image (B) at test positions (P, P1, P1', P2).

**2.** Method according to claim 1, wherein first test positions (P1) are positioned in the test image (B) according to a predetermined first test grid.

**3.** Method according to claim 2, wherein the predetermined first test grid uniformly covers a target volume of the test image (B).

**4.** Method according to one of the preceding claims, wherein the assignment function (M) takes into account a minimal intensity value.

**5.** Method according to one of the preceding claims, wherein the selection of test positions (P, P1, P1', P2) comprises a weighting of test positions (P, P1, P1', P2) according to a weighting factor dependent on an intensity value of the test image (B) at a respective test position, wherein a weighting with the weighting factor zero corresponds to a blockage of the test position (P, P1, P1', P2).

**6.** Method according to one of the preceding claims, wherein blocked test positions, in particular blocked first test positions (P1), are moved to second test positions (P2) which are assigned to permitted or blocked test positions in accordance with the assignment function (M).

**7.** Method according to claim 6, wherein for rows or columns of the first test grid the movement of the first test positions (P1) takes place row by row or column by column.

**8.** Method according to claim 6, wherein individually blocked first test positions (P1) can be moved to second test positions (P2) in at least one spatial direction (x,y) of the test image (B) in the direction of the image centre of the test image (B) or to a second test position (P2) with a desired intensity value in the test image (B).

**9.** Method according to one of the preceding claims, wherein candidate test positions (P0) are positioned according to a second predetermined test grid, which is more closely meshed than the first grid, and assigned to permitted or blocked test positions according to the assignment function (M), and blocked first test positions (P1) are moved to permitted, in particular to spatially nearest, permitted candidate positions (P0).

**10.** Method according to one of the preceding claims, wherein the selection of test positions (P, P1') comprises a distribution of a predetermined number of test positions (P, P1') in a region (A2') permitted according to an approval criterion (Z) based on intensity values of the test image (B) and defining in particular a predetermined minimal intensity value.

**11.** Method according to one of the preceding claims, wherein the test positions for methods for the compensation of effects of deviations of gradients actually generated during a readout duration from gradients planned for this readout duration, in particular for a PSF determination, are determined.

**12.** Magnetic resonance system (1) comprising a magnet unit (3), a gradient unit (5), a radio-frequency unit (7) and a control facility (9) with a radio-frequency transmitting/receiving control system (7') and a test position determining unit (15), wherein the control device (9) is configured to carry out a method as claimed in one of claims 1 to 11 on the magnetic resonance system (1).

**13.** Computer program which can be directly loaded into a memory store of a control facility (9) of a magnetic resonance system (1), having program means in order to carry out the steps of the method according to one of claims 1 to 11 when the program is executed in the control facility (9) of the magnetic resonance system (1).

**14.** Electronically readable data carrier comprising electronically readable control information stored thereon, which information comprises at least one computer program according to claim 13 and is designed such that when the data carrier is used in a control facility (9) of a magnetic resonance system (1), it performs a method according to one of claims 1 to 11.

**Revendications**

**1.** Procédé de détermination d'au moins une position d'essai pour une mesure d'essai à enregistrer au moyen d'une installation de résonance magnétique comprenant les stades :

- enregistrement d'une image (B) d'essai,
- choix d'au moins une position (P, P1, P1', P2) d'essai sur la base de l'image (B) d'essai,

dans lequel le choix de positions (P, P1, P1', P2) d'essai comprend une affectation de positions (P, P1, P1', P2) d'essai à des positions d'essai autorisées et à des positions d'essai interdites suivant une fonction (M) d'affectation reposant sur des valeurs d'intensité de l'image (B) d'essai à des positions (P, P1, P1', P2) d'essai.

**2.** Procédé suivant la revendication 1, dans lequel des premières positions (P1) d'essai sont positionnées dans l'image (B) d'essai suivant une première grille d'essai donnée à l'avance.

**3.** Procédé suivant la revendication 2, dans lequel la première grille d'essai donnée à l'avance recouvre uniformément un volume cible de l'image (B) d'essai.

**4.** Procédé suivant l'une des revendications précédentes, dans lequel la fonction (M) d'affectation prend en compte une valeur d'intensité minimum.

**5.** Procédé suivant l'une des revendications précédentes, dans lequel le choix de positions (P, P1, P1', P2) d'essai comprend une pondération de positions (P, P1, P1', P2) d'essai suivant un facteur de pondération, qui dépend d'une valeur d'intensité de l'image (B) d'essai à une position d'essai respective, dans lequel une pondération par le facteur de pondération zéro correspond à une interdiction de la position (P, P1, P1', P2) d'essai.

**6.** Procédé suivant l'une des revendications précédentes, dans lequel on décale des positions d'essai interdites, en particulier des premières positions (P1) d'essai interdites à des deuxièmes positions (P2) d'essai, que l'on affecte suivant la fonction (M) d'affectation à des positions d'essai autorisées ou interdites.

**7.** Procédé suivant la revendication 6, dans lequel le décalage de premières positions (P1) d'essai a lieu ligne par ligne ou colonne par colonne pour des lignes ou des colonnes de la première grille d'essai.

**8.** Procédé suivant la revendication 6, dans lequel on décale diverses positions (P1) d'essai interdites sur des deuxièmes positions (P2) d'essai dans au moins une direction (x, y) de l'espace de l'image (B) d'essai en direction du centre de l'image (B) d'essai ou sur une deuxième position (P2) d'essai ayant une valeur d'intensité très souhaitée dans l'image (B) d'essai.

**9.** Procédé suivant l'une des revendications précédentes, dans lequel on positionne des positions (P0) d'essai candidates suivant une deuxième grille d'essai donnée à l'avance, qui est à maille plus étroite que la première grille d'essai, et on les affecte suivant la fonction (M) d'affectation à des positions d'essai autorisées ou interdites et on décale des premières positions (P1) d'essai interdites sur des positions (P0) candidates autorisées, en particulier autorisées, qui sont les plus proches dans l'espace.

**10.** Procédé suivant l'une des revendications précédentes, dans lequel le choix de positions (P, P1') d'essai comprend une répartition d'un nombre donné à l'avance de positions (P, P1') d'essai dans une plage (A2') autorisée suivant un critère (Z) d'admission reposant sur des valeurs d'intensité de l'image (B) d'essai fixant, en particulier, une valeur d'intensité minimum donnée à l'avance.

**11.** Procédé suivant l'une des revendications précédentes, dans lequel on détermine, en particulier pour une détermination PSF, des positions d'essai pour des procédés de compensation d'effets d'écarts de gradient, produits réellement pendant un laps de temps de lecture, par rapport à des gradients planifiés pour ce laps de temps de lecture.

**12.** Installation (1) de résonance magnétique, comprenant une unité (3) d'aimant, une unité (5) de gradient, une unité (7) de haute fréquence et un dispositif (9) de commande ayant une commande (7') d'émission/réception en haute fréquence et comprenant une unité (15) de détermination de position d'essai, dans laquelle le dispositif (9) de commande est constitué pour exécuter un procédé suivant l'une des revendications 1 à 11 sur l'installation (1) de résonance magnétique.

**13.** Programme d'ordinateur, qui peut être chargé directement dans la mémoire d'un dispositif (9) de commande d'une installation (1) de résonance magnétique, comprenant des moyens de programme pour exécuter les stades du procédé suivant l'une des revendications 1 à 11, lorsque le programme est exécuté dans le dispositif (9) de commande de l'installation (1) de résonance magnétique.

**14.** Support de données déchiffrable électroniquement, sur lequel sont mises en mémoire des informations de commande pouvant être déchiffrées électroniquement, lesquelles comprennent au moins un programme d'ordinateur suivant la revendication 13 et qui sont conformées, de manière à ce que lors de l'utilisation du support de données dans un dispositif (9) de commande d'une installation (1) de résonance magnétique, elles exécutent un procédé suivant l'une des revendications 1 à 11.

## FIG 1

101

TB

101'

E

M,Z

103

P

105

K

MD,BD

107

MD*,BD*

## FIG 2

## FIG 3

FIG 4

FIG 5

# FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8981776 B2

- US 20130154639 A1

**In der Beschreibung aufgeführte Nicht-Patentliteratur**

- **VON BREUER et al.** Controlled Aliasing in Parallel Imaging Results in Higher Acceleration (CAIPIRINHA) for Multi-Slice Imaging. *Magnetic Resonance in Medicine,* 2005, vol. 53, 684-691
- **SETSOMPOP et al.** Blipped-Controlled Aliasing in Parallel Imaging for Simultaneous Multislice Echo Planar Imaging With Reduced g-Factor Penalty. *Magnetic Resonance in Medicine,* 2012, vol. 67, 1210-1224
- **BILGIC et al.** Wave-CAIPI for Highly Accelerated 3D Imaging. *Magnetic Resonance in Medicine,* 2015, vol. 73, 2152-2162

- **CHEN et al.** Self-Calibrating Wave-Encoded Variable-Density Single-Shot Fast Spin Echo Imaging. *J. Magn. Reson. Imaging,* 2018, vol. 47, 954-966
- **GAGOSKI et al.** RARE/Turbo Spin Echo Imaging with Simultaneous Multislice Wave-CAIPI. *Magn. Reson. Med.,* 2015, vol. 73, 929-938
- **POLAK et al.** Highly-Accelerated Volumetric Brain Examination Using Optimized Wave-CAIPI Encoding. *J. Magn. Reason. Imaging,* 2019, vol. 50, 961-974
- **CAULEY et al.** Autocalibrated Wave-CAIPI Reconstruction; Joint Optimization of k-Space Trajectory and Parallel Imaging Reconstruction. *Magnetic Resonance in Medicine,* 2017, vol. 78, 1093-1099